# EUROPÄISCHE PATENTSCHRIFT

(11) **EP 1 629 576 B1**
(45) Veröffentlichungstag und Bekanntmachung des Hinweises auf die Patenterteilung: **13.12.2006**
(21) Anmeldenummer: 04735225.7
(22) Anmeldetag: 28.05.2004
(51) Int. Cl.: H01S 3/06

(54) **VERFAHREN UND VORRICHTUNG ZUM PUMPEN EINES LASERS**
METHOD AND DEVICE FOR PUMPING A LASER
PROCEDE ET DISPOSITIF POUR POMPER UN LASER

(30) Priorität: 30.05.2003 US 474227 P; 23.10.2003 CH 181603
(43) Veröffentlichungstag der Anmeldung: 01.03.2006
(73) Patentinhaber: High Q Laser Production GmbH, 6845 Hohenems (AT)
(72) Erfinder: KOPF, Daniel, A-6844 Altach (AT); LEDERER, Maximilian Josef, A-6861 Alberschwende (AT); JOHANNSEN, Ingo, A-6923 Lauterach (AT)
(74) Vertreter: Harmann, Bernd-Günther
(86) Internationale Anmeldenummer: PCT/EP2004/005813
(87) Internationale Veröffentlichungsnummer: WO 2004/107514

(56) Entgegenhaltungen:
- EP-A- 1 204 182
- EP-A- 1 333 547
- WO-A-00/77893
- US-A- 5 485 482
- US-A1- 2002 039 377
- US-A1- 2003 160 034
- ZAPATA L E ET AL: "High power Yb:YAG/YAG composite thin disk laser" CONFERENCE ON LASERS AND ELECTRO-OPTICS. (CLEO 2001). TECHNICAL DIGEST. POSTCONFERENCE EDITION. BALTIMORE, MD, MAY 6-11, 2001, TRENDS IN OPTICS AND PHOTONICS. (TOPS), US, WASHINGTON, WA : OSA, US, Bd. VOL. 56, 6. Mai 2001 (2001-05-06), Seiten 334-335, XP010559907 ISBN: 1-55752-662-1

## Beschreibung

Die Erfindung betrifft ein Verfahren zum Pumpen eines Lasers nach dem Oberbegriff des Anspruchs 1, ein Laserelement nach dem Oberbegriff des Anspruchs 9, sowie eine Laseranordnung nach dem Oberbegriff des Anspruchs 16.

Eine grundsätzliche Anforderung an Laser-Set-ups für industrielle wie wissenschaftliche Anwendungen ist die möglichst hohe Einkopplung von Leistung in ein laseraktives Medium. Dies erfolgt bei einem weit verbreiteten Typ von Festkörper-Lasern durch Pumpen mittels Licht, das von einem oder mehreren Halbleiterlasern emittiert und auf den Festkörper mit oder aus laseraktivem Material geführt wird. Beim Pumpen erwärmt sich der Festkörper, so daß eine erhöhte Leistungseinkopplung mit einer grundsätzlich unerwünschten Temperatursteigerung einhergeht.

Die Probleme durch thermische Belastungen entstehen bei diesen Systemen einerseits durch Beschädigungen des Festkörpers selbst oder aber aufgrund unerwünschter Einflüsse auf das Strahlungsfeld im Festkörper. Ein Beispiel für einen solchen Effekt sind thermische Linsen.

Eine diese Effekte beeinflussende kritische Grösse ist die Wärmeleitung innerhalb des Festkörpers wie auch der Wärmetransport durch die Grenzflächen bzw. Grenzschichten des laseraktiven Festkörpers. Eine Standardlösung zur Verringerung der thermischen Effekte stellt der Thin-Disk-Laser dar, wie er beispielsweise aus der EP 0 632 551 B1, und der EP 1 204 182 A2 bekannt ist.

Bei solchen Lasern wird das Lasermedium als flache Scheibe ausgebildet und mit einer seiner Flachseiten auf eine Temperatursenke aufgebracht, die meist als massives Kühlelement ausgebildet ist. Durch das günstige Verhältnis von Oberfläche zu Volumen kann ein Wärmetransport auch bei hohen Transportleistungen erreicht werden, der eine hinreichende Kühlung des Lasermediums bewirkt und somit negative Auswirkungen auf Material und Strahlungsfeld verhindert. Dabei bildet sich durch die flächenhafte Ausgestaltung des Materials ein Temperaturgradient aus, der im Kernbereich des Strahlungsfeldes parallel zu dessen Ausbreitungsrichtung verläuft. Damit kann eine vergleichsweise Homogenität der Temperatur über einen grossen Bereich des Strahlquerschnittes erreicht werden, so daß der Wärmefluß im wesentlichen eindimensional verläuft und thermische Linsen vermieden werden. Die zum Pumpen solcher Laser verwendeten Strahlquerschnitte werden zur Erzielung dieses eindimensionalen Wärmeflusses rund ausgestaltet und an die Geometrie des Lasermaterials angepasst.

Lösungen des Stand der Technik, wie sie bspw. auch aus "Widely tunable pulse durations from a passively modelocked thin-disk Yb:YAG laser", F. Brunner et al. (Optics Letters 26, No. 2, Seiten 379-381) oder "60-W average power in 810-fs pulses from a thin-disk Yb:YAG laser", E. Innerhofer et al. (Optics Letters 28, No. 5, Seiten 367-369) bekannt sind, betonen die Eindimensionalität des Wärmeflusses und bestreben eine Optimierung des Verhältnisses von Oberfläche zu Volumen, indem eine Dimension des Lasermediums möglichst klein, die beiden anderen Dimensionen hingegen möglichst gross, zumindest aber deutlich größer als die Dicke des Lasermediums, gehalten werden. Die beiden Dokumente werden hiermit als mittels Referenzierung vollumfänglich einbezogen angesehen.

Damit erfolgt nach dem Stand der Technik eine Auslegung des Lasers zur Erzielung niedriger Temperaturen bzw. eines günstigen Wärmeflusses vor allem durch eine Verringerung der Schichtdicke des Lasermediums bei einem geometrisch angepaßten Pumplichtfleck.

Ein weiteres Problem stellt die Fokussierung der Pumplichtquellen in einen runden Fleck dar. Die Abbildung vieler Pumplaser in einen Fleck erfordert einen vergleichsweise grossen apparativen Aufwand, der auch mit Schwierigkeiten der Justierung verbunden ist.

Ein weiteres Problem besteht in der Handhabung der dünnen, plättchenartigen Lasermedien beim Aufbringungsvorgang, insbesondere da eine weiter zunehmende Verringerung der Dicke auch eine verringerte Resistenz gegenüber mechanischen Beanspruchungen beinhaltet.

Eine Aufgabe besteht somit darin, eine gegenüber dem Stand der Technik geringere Temperatur des Lasermediums bei gleicher eingestrahlter Leistung und Leistungsdichte - und somit gleichem rechnerischen Verstärkungsfaktor - oder aber eine höhere einstrahlbare Leistung bei gleicher Temperatur zu erreichen, ohne daß nicht tolerierbare oder nicht berücksichtigbare thermische Effekte auftreten.

Eine weitere Aufgabe besteht in der Vereinfachung der Strahlführung zur Abbildung der Pumplichtquellen in einem Pumplichtfleck.

Eine weitere Aufgabe besteht in der Vereinfachung des Aufbaus des Lasers, insbesondere in der Verringerung der notwendigen Komponenten und der Vereinfachung der Ausrichtung der Komponenten.

Eine weitere Aufgabe besteht in der Erhöhung der Stabilität des Lasermediums, insbesondere in Hinblick auf die Handhabung der Komponenten während der Fertigung.

Diese Aufgaben werden erfindungsgemäss durch Merkmale des Anspruchs 1, 9, bzw. 16 oder durch Merkmale der Unteransprüche gelöst bzw. die Lösungen weitergebildet.

Erfindungsgemäss wird das Lasermedium in einem Thin-disk-Laser durch einen länglichen bzw. elliptischen Pumplichtfleck ausgeleuchtet. Dieser Pumplichtfleck weist eine grundsätzlich längliche Form auf, wobei das Verhältnis von Länge zu Breite bei 2:1, 3:1, 5:1, 10:1 oder noch höher liegen kann. Insbesondere kann auch ein High-Aspect-Ratio-Laserspot erfindungsgemäss verwendet werden. Durch den länglichen Pumplichtfleck wird ein zweidimensionaler Wärmefluß bewirkt, der im Vergleich zu Lösungen des Stands der Technik zu einer Verringerung der Maximaltemperatur führt.

In Anpassung an die Geometrie des Pumplichtflecks kann auch der Festkörper als ein länglicher, flächiger oder barrenartiger Festkörper ausgebildet werden, wobei jedoch grundsätzlich auch Abweichungen zwischen den Geometrien von Pumplichtfleck und Lasermedium die erfindungsgemäße Wirkung ermöglichen. Für eine erfindungsgemässe Anpassung an die längliche Pumplichtgeometrie wird wenigstens eine erste Dimension des Festkörpers deutlich grösser als die Dicke des Festkörpers gewählt. Die andere Dimension ist zur Erzielung einer zweidimensionalen Kühlung deutlich geringer als die erste Dimension. Bezogen auf die Dicke des Festkörpers kann diese Dimension kleiner, gleich oder größer als die Dicke des Festkörpers gewählt werden. Eine Verbesserung der Kühlung wird somit erfindungsgemäss erreicht, indem eine der beiden flächenhaften Dimensionen der Kühloberfläche gegenüber der anderen stark vergrößert wird. Durch erfindungsgemäß geeignete Wahl der Dimensionen des Lasermediums kann damit bei gleicher Leistung die maximale Temperatur gegenüber z.B. der scheibchenförmigen Form des Lasermediums stark verringert werden. Dieses Lasermedium wird in an sich bekannter Weise auf eine Temperatursenke aufgebracht. Zwischen Temperatursenke und Lasermedium kann eine reflektierende Schicht eingebracht werden. Gleichfalls kann das Lasermedium auf der der Kühlung abgewandten Seite ein oder mehrere Schichten, bspw. zur Reflexverminderung, tragen.

Auf das Lasermedium wird Pumplicht in Form eines Pumplichtfleckes abgebildet, wobei Geometrien der Fläche des Lasermediums und des Pumplichtflecks vorteilhaft aufeinander abgestimmt sein können. Dabei kann der Pumplichtfleck auch aus der Abbildung einzelner Emitter zusammengesetzt sein oder durch mehrfache Reflexion gebildet werden. Ein Beispiel für eine geeignete Überlagerung der Strahlung verschiedener Emitter wird in der WO 00/77893 bzw. US Patentanmeldung No. 10/006,396 geoffenbart. Eine geeignete Lösung zur Erzeugung einer mehrfachen Reflexion wird in der US Provisional Patentanmeldung No. 60/442,917 beschrieben. Ein darin beschriebenes erfindungsgemässes Faltelement weist wenigstens zwei aufeinander zulaufende bzw. verkippte reflektierende Ebenen auf, zwischen denen der Strahlgang geführt wird. Dabei können diese Ebenen sowohl Aussenflächen mehrerer spiegelnder Elemente als auch die Innenseiten eines einzigen Elements darstellen. D.h. die Reflexion findet an einem Übergang von wenigstens zwei Medien unterschiedlicher optischer Brechzahl statt. Alle aufgeführten Dokumente werden hiermit als mittels Referenzierung vollumfänglich einbezogen angesehen.

Hinzu kommt, daß durch die längliche Form des Pumplichtflecks eine homogene Temperatur im größten Teil des Flecks entsteht, die einen Wärmetransport in dessen Längsrichtung verhindert. Der Wärmefluß erfolgt somit im wesentlichen quer zur Längsrichtung des Lasermediums bzw. zur Temperatursenke und damit zweidimensional. Im Vergleich zu einer runden Geometrie des Pumplichtflecks ist die Maximaltemperatur stark erniedrigt, so daß bei gleicher Leistung auch quer zur Strahlrichtung eine in der Größenordnung der runden Geometrie liegende Temperaturdifferenz pro Längeneinheit auftritt, so daß durch die thermische Linsenbildung auftretende Effekte vernachlässigbar sind oder zumindest kompensierbar bleiben. So kann beispielsweise mit einem länglichen, bspw. elliptischen, Pumpspot von 10 mm Länge und 0,1 mm Breite die gleiche Fläche eines runden Pumpspots von 1 mm² jedoch bei verbesserter Kühlung genutzt werden. Zwar wird bei einer erfindungsgemäßen länglichen Ausgestaltung von Lasermedium und gepumpter bzw. ausgeleuchteter Fläche der Effekt rein flächenhafter Kühlung verringert, jedoch kann durch die stark verringerte Maximaltemperatur auch bei mehrdimensionalem Wärmefluss die Auswirkung von thermischen Linsen gering gehalten werden.

Zur weiteren Verbesserung der Kühlwirkung und zur Erhöhung der mechanischen Belastbarkeit kann auch das Lasermedium auf der der Temperatursenke entgegengesetzten Seite eine weitere Schicht aus einem Material mit dem gleichen Brechungsindex des Lasermediums aufgebracht werden. Vorteilhaft ist eine Schicht aus dem gleichen Material des laseraktiven Mediums, wobei dieses jedoch nicht dotiert ist. Eine Verbindung beider Schichten kann durch eine Diffusionsbindung erfolgen. Durch eine solche weitere Schicht erfolgt auch ein verbesserter Wärmetransport durch die Kühloberfläche in einer der Temperatursenke entgegengesetzten Richtung, so daß die Kühlung nochmals verbessert und eine weitere Reduzierung der Maximaltemperatur erreicht wird. Daneben wird die mechanische Stabilität des Lasermediums erhöht und dadurch der Herstellprozeß verbessert bzw. vorteilhafter gestaltbar.

Die erfindungsgemässe Dimensionierung des Pumplichtflecks und die Anpassung von Pumplichtfleck und Lasermedium sowie damit realisierbare erfindungsgemäße Laseranordnungen werden nachfolgend anhand von in der Zeichnung schematisch dargestellten Ausführungsbeispielen rein beispielhaft näher beschrieben. Im einzelnen zeigen
- Fig.1: die schematische Darstellung von Lasermedium und Pumplichtstrahl einer erfindungsgemäßen Laseranordnung;
- Fig.2a-b: die schematische Darstellung der Pumplichtgeometrien bei der Abbildung auf das Lasermedium;
- Fig.3: die schematische Darstellung eines Strahlgangs mit multipler Reflexion in einer erfindungsgemässen Laseranordnung;
- Fig.4: die schematische Darstellung der Abbildung von Pumplicht auf das Lasermedium für eine Ausführungsform der erfindungsgemässen Laseranordnung mit multipler Reflexion;
- Fig.5a-b: die schematische Darstellung von erfindungsgemäßen Schichtaufbauten des zu pumpenden Festkörpers;
- Fig.6: die schematische Darstellung von vorteilhaften Formen des erfindungsgemäß zu pumpenden Festkörpers;
- Fig.7: die schematische Darstellung einer ersten Ausführungsform des erfindungsgemäß zu pumpenden Festkörpers;
- Fig.8: die schematische Darstellung einer zweiten Ausführungsform des erfindungsgemäß zu pumpenden Festkörpers;
- Fig.9: die Modellierung eines Festkörpers mit Pumplichtfleck nach dem Stand der Technik mittels der Methode der finiten Elemente;
- Fig.10: den Temperaturverlauf in X-Richtung durch den Festkörper nach Fig.9;
- Fig.11: den Temperaturverlauf in Y-Richtung durch den Festkörper nach Fig.9;
- Fig.12: den Temperaturverlauf in Z-Richtung durch den Festkörper nach Fig.9;
- Fig.13: die Modellierung eines ersten Festkörpers mit erfindungemäßem Pumplichtfleck mittels der Methode der finiten Elemente;
- Fig.14: den Temperaturverlauf in X-Richtung durch den Festkörper nach Fig.13;
- Fig.15: den Temperaturverlauf in Y-Richtung durch den Festkörper nach Fig.13;
- Fig.16: den Temperaturverlauf in Z-Richtung durch den Festkörper nach Fig.13;
- Fig.17: die Modellierung eines erfindungsgemäßen zweiten Festkörpers mit erfindungsgemäßem Pumplichtfleck mittels der Methode der finiten Elemente;
- Fig.18: den Temperaturverlauf in X-Richtung durch den Festkörper nach Fig.17;
- Fig.19: den Temperaturverlauf in Y-Richtung durch den Festkörper nach Fig.17;
- Fig.20: den Temperaturverlauf in Z-Richtung durch den Festkörper nach Fig.17 und
- Fig.21: die schematische Darstellung einer erfindungsgemäßen Laseranordnung.

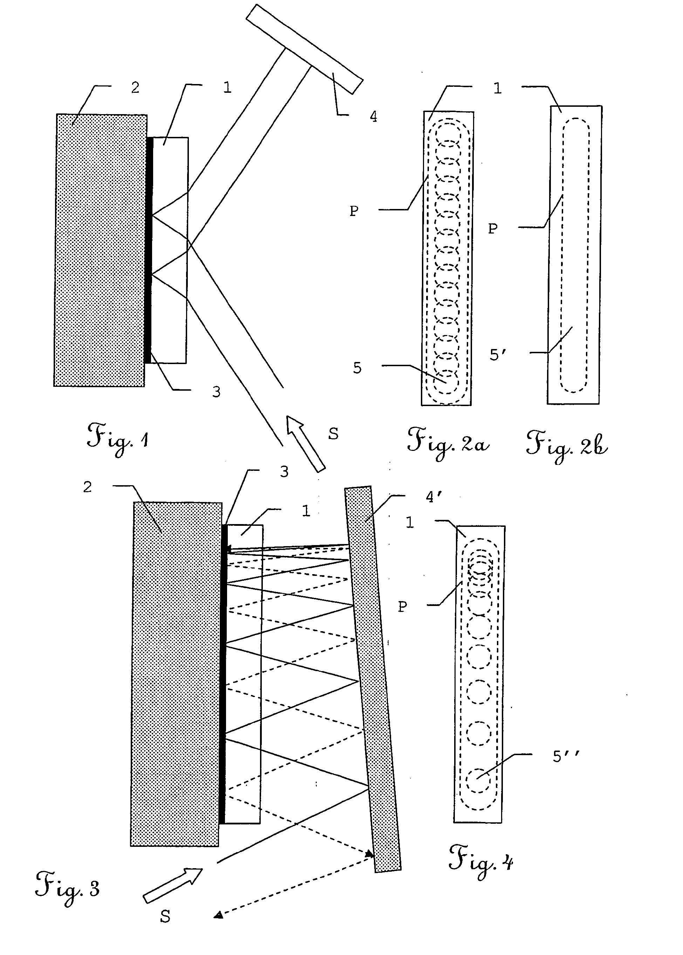

In Fig.1 werden ein Lasermedium 1 und ein Pumplichtstrahl S für eine erfindungsgemässe Laseranordnung dargestellt. Dabei ist das dünne Lasermedium 1 auf einer Temperatursenke 2 angebracht, die als gekühlter Festkörper ausgebildet ist. Der Teilstrahl S eines Pumplichtstrahls fällt unter einem Winkel (z.B.: Brewster-Winkel) auf das Lasermedium 1 und wird nach Passieren desselben von einer Reflexionsschicht 3, die zwischen Lasermedium 1 und Temperatursenke 2 angebracht ist, reflektiert. An einem Spiegel 4 wird der Pumplichtstrahl S in sich zurück reflektiert und passiert erneut das Lasermedium 1 mit einer Reflexion an der Reflexionsschicht 3.

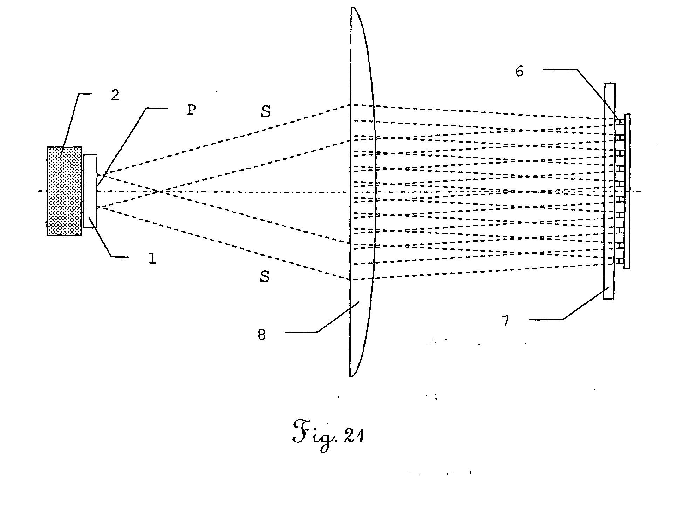

Mögliche Beispiele von erfindungsgemäß geeigneten Pumplichtgeometrien zeigen die Fig.2a-b. Der auf das Lasermedium 1 abgebildete Pumplichtfleck in Fig.2a setzt sich aus einer aneinandergereihten Folge von Projektionen 5 zusammen, die zusammen einen Pumplichtfleck P definieren, wobei diese entweder von verschiedenen Emittern bzw. Lichtquellen stammen oder aber auch durch mehrfache Abbildung der Strahlung einer Lichtquelle, z.B. durch mehrfache Reflexionen, erzeugt werden können. In ihrer Gesamtheit bilden diese einzelnen Projektionen 5, die hier nur rein exemplarisch als rund und mit nur geringem Überlapp dargestellt werden, einen gemeinsamen und im wesentlichen länglichen bzw. elliptischen Pumplichtfleck P, welcher vorteilhafterweise der Geometrie des Lasermediums 1 folgt. Fig.2b zeigt als weitere Alternative die Ausbildung eines einzelnen, homogenen Pumplichtflecks P, der beispielsweise durch die entsprechend geformte Projektion der 5'Strahlung eines einzigen Emitters gebildet werden kann. Vorteilhafterweise kann aber das identisch geformte Licht mehrerer Emitter zu einem homogenen Pumplichtfleck überlagert werden. Eine hierfür geeignete Lösung wird in der WO 00/77893 beschrieben und in Fig.21 weiter ausgeführt. Besonders vorteilhaft kann auch die ohnehin längliche Anordnung von Halbleiterlasern in einem ein- oder mehrzeiligen Linear-Array ausgenutzt werden, um einen länglichen Plumplichtfleck zu erzeugen.

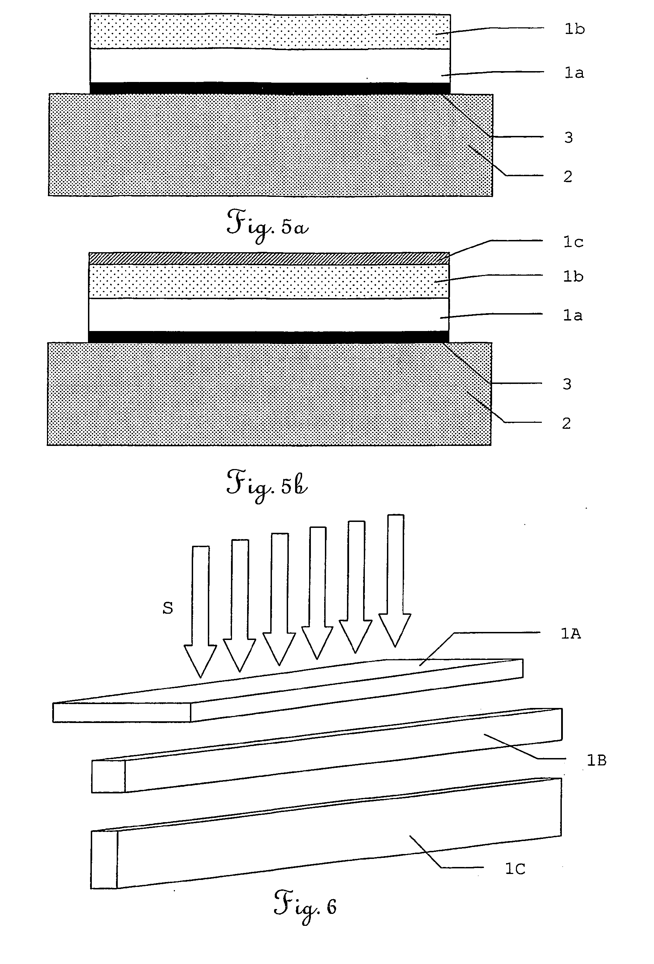

In Fig.3 wird ein Beispiel der Verwendung mehrfacher Reflexionen zur Erzeugung eines länglichen Pumplichtflecks P erläutert. Wie beispielsweise in der US Provisional Patentanmeldung No. 60/442,917 geoffenbart, kann durch eine gegenüber einer anderen Oberfläche verkippte Spiegelfläche 4' eine mehrfache Reflexion mit veränderlichem Abstand der Reflexionspunkte erreicht werden, die nach einer gewissen Anzahl von Reflexionen zur Umkehr der Richtung führt. In diesem Beispiel erfolgen die Reflexionen zwischen der Spiegelfläche 4' und der Reflexionsschicht 3, die wiederum zwischen Lasermedium 1 und Temperatursenke 2 angebracht ist. Der Pumplichtstrahl S wird bei diesem Setup von einer Seite ein- und wieder ausgekoppelt, so daß eine konstruktiv vorteilhafte Anordnung möglich wird. Alternativ kann aber auch die Spiegelfläche 4' planparallel zur Reflexionsschicht 3 angeordnet sein, so daß eine Richtungsumkehr des Teilstrahls S durch einen weiteren Spiegel in an sich bekannter Weise erfolgt.

In analoger Weise können auch der Lasermode und damit das zu verstärkende Strahlungsfeld mehrfach durch das Lasermedium geführt werden und somit mehrfache Verstärkung erfahren.

Fig.4 zeigt schematisch die Ausbildung eines erfindungsgemäßen Pumplichtflecks P auf einem Lasermedium 1 bei einer Anordnung nach Fig.3. Die einzelnen Projektionen 5" bzw. Reflexionen erfolgen in diesem Beispiel mit veränderlichem Abstand, so daß die dadurch gebildeten einzelnen Projektionen 5'' unterschiedliche Entfernungen zueinander aufweisen. Durch geeignete Wahl von Strahldurchmesser, Strahlkonvergenz und -divergenz, Entfernung und Winkel der reflektierenden Flächen zueinander kann die Folge der Reflexionspunkte bis hin zu einem weitgehenden Überlapp variiert werden, so dass ein weitgehend homogener Pumplichtfleck P entsteht.

Ein möglicher Aufbau des das Lasermedium enthaltenden Festkörpers zeigen Fig.5a-b. In Fig.5a besteht der Aufbau in einer auf der Temperatursenke 2 aufgebrachten Schichtfolge aus Reflexionsschicht 3, dotiertem Festkörpermaterial 1a und nicht-dotiertem Festkörpermaterial 1b. Die beiden Festkörpermaterialien können als separate Elemente durch Diffusionsbindung (Diffusion Bonding) oder andere Verbindungsverfahren miteinander verbunden werden. Eine Erweiterung der Schichtfolge wird in Fig.5b dargestellt. Hier wird zusätzlich auf das nichtdotierte Festkörpermaterial 1b eine zusätzlich reflexmindernde und/oder abriebfeste Schicht 1c aufgebracht. Gegebenenfalls kann diese Schicht 1c auch die Funktion der reflektierenden Fläche aus Fig.3 übernehmen, so daß die multiple Reflexion vollständig im Inneren des Festkörpers erfolgt.

In Fig.6 werden schematisch verschiedene geometrische Ausbildungsformen eines das Lasermedium beinhaltenden Festkörpers dargestellt. Dargestellt werden zwei rein exemplarische Ausführungsformen des erfindungsgemäßen laseraktiven Festkörpers 1A-13 sowie eine weitere Ausführungsform eines Festkörpers 1C, wobei diese in ihrer Orientierung bezüglich der Folge von einfallenden Teilstrahlen S als Pumplichtstrahls dargestellt werden. Die erste Ausführungsform des Festkörpers 1A ist plättchenförmig ausgebildet, wobei die beiden Kanten, welche die dem Pumplichtstrahl zugewandte Einstrahlfläche definieren, größer als die Dicke des Festkörpers 1A sind. Eine zweite Ausführungsform des Festkörpers 1B besitzt zwei Kanten gleicher Länge, wobei die dritte Kante eine vergleichsweise grosse Länge aufweist, so daß der Festkörper einem Barren mit quadratischem Querschnitt entspricht. Bei der dritten Ausführungsform des Festkörpers 1c ist eine der beiden Kanten, welche die dem Pumplichtstrahl zugewandte Einstrahlfläche definieren, sehr viel größer als die Dicke des Festkörpers 1C wohingegen die andere Kante geringfügig kleiner als diese Dicke ist. Damit entspricht der Festkörper 1C in seiner Orientierung gegenüber den Teilstrahlen S einem Barren mit rechteckigem Querschnitt, der auf seiner Schmalseite steht. Allerdings nimmt die erfindungsgemäße Wirkung mit zunehmender Abweichung von einem flächigen Kontakt - wie er bei einer plättchenförmigen ersten Ausführungsform des Festkörpers 1A entsteht - ab, so dass für die dritte Ausführungsform mit zunehmendem Verhältnis von Seiten- zu Standfläche die erfindungsgemäße Wirkung reduziert wird und schliesslich nur noch ein vorwiegend eindimensionaler Wärmefluß folgt.

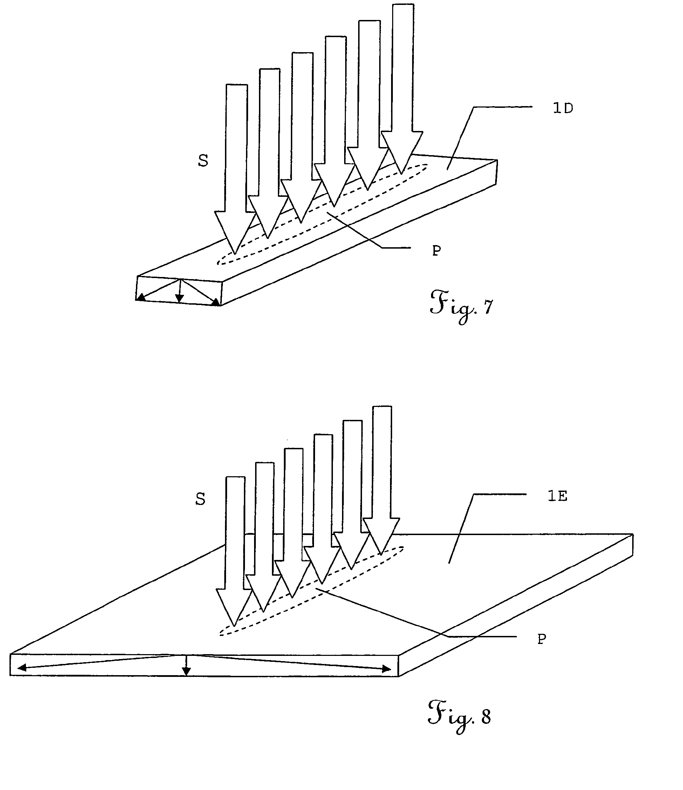

Fig.7 stellt schematisch die besonders vorteilhafte Anpassung von Pumplichtfleck P und Festkörper 1D dar. Die Geometrie des Festkörpers 1D wird so gewählt, dass sie der Geometrie des Pumplichtflecks P im wesentlichen entspricht. Dadurch kann eine weitgehende Ausleuchtung des Festkörpers 1D durch eine Folge von Teilstrahlen S als Pumplichtstrahl und eine erfindungsgemäße Kühlwirkung erreicht werden. Gleichzeitig erlaubt eine solche Anpassung eine kompakte bzw. flache Bauweise und eine direkte Abbildung von linearen Anordnungen der Emitter oder einer linearen Abstrahlgeometrie eines einzigen Emitters, so dass eine geringe Komplexität des Aufbaus möglich wird.

Fig.8 zeigt die schematische Darstellung einer zweiten Ausführungsform des erfindungsgemäß zu pumpenden Festkörpers. Bei dieser Ausführungsform wird auf eine weitgehende Anpassung der Geometrien von zu pumpenden Festkörper 1E und Pumplichtfleck P verzichtet. Bei dieser Ausführungsform wird nur ein Teil des Festkörpers 1E durch eine Folge von Teilstrahlen S als Pumplicht ausgeleuchtet. Durch eine solche Auslegung kann bewirkt werden, dass der horizontale und quer zur Längsrichtung erfolgende Temperaturabfall pro Längeneinheit des Pumplichtflecks P geringer gehalten wird. Allerdings folgen für diese Ausführungsform bei gleicher Grösse des Pumplichtflecks P grössere Abmessungen, so dass im Vergleich zur ersten Ausführungsform nach Fig.7 auf Möglichkeiten zur kompakten Gestaltung des Lasers verzichtet werden muß.

Die in den Fig. 9-20 dargestellten Modelle bzw. Ergebnisse wurden mit der Methode der finiten Elemente berechnet. Die Berechnungen erfolgten unter Verwendung des Programms "Flex PDE 3D". Dabei wurden nur die Temperaturverteilungen berechnet und Spannungen oder Verbiegungen vernachlässigt. Das Berechnungsgitter wird vom Programm selbst festgelegt. Das Simulationsproblem wurde halbiert, d.h. die Hälfte des Materials wurde aufgrund der Spiegelsymmetrie vernachlässigt. Als Material des Festkörpers wurde mit 1% Neodym dotiertes Vanadat zugrundegelegt.

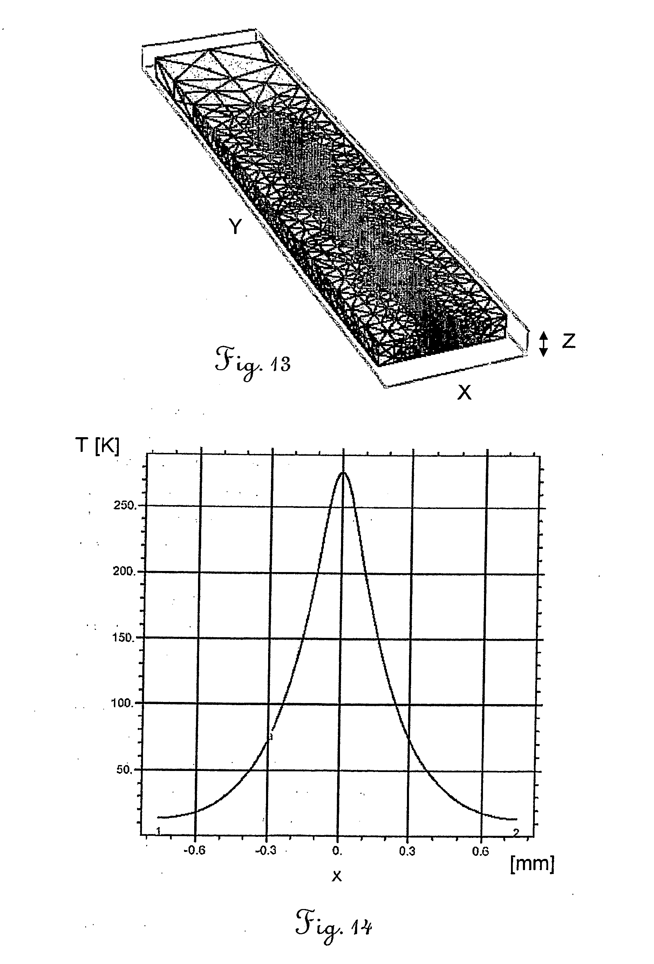

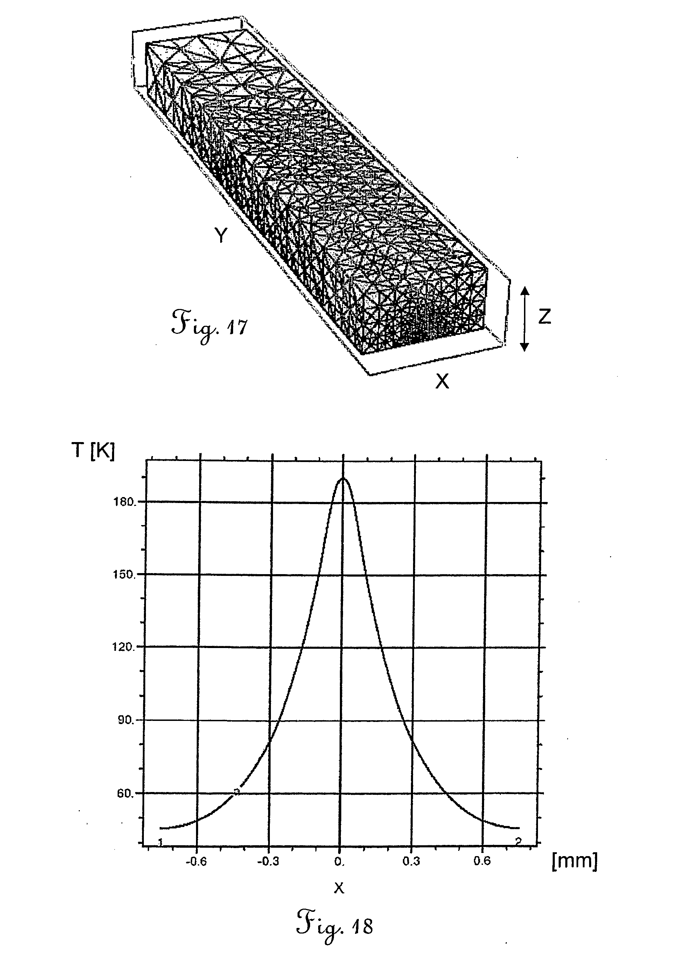

Bemassung des Festkörpers:
halbe Länge 7.5mm (Fig.13 und Fig.17), 2.5mm (Fig.9)
Breite 1.5mm (Fig.13 und Fig.17), 5mm (Fig.9)
Höhe 0.3mm (+0.6mm für Fig.17)

Die kontaktierte Kühlfläche wird auf eine Temperatur fixiert, die anderen Flächen sind hinsichtlich der Temperatur frei und ungekühlt. Daraus folgt, dass sämtliche Temperaturen der Simulation die Differenz zur Kühltemperatur angeben. Zur Berechnung der dreidimensionalen Pumplichtverteilung im Material wurde das Programm MATLAB herangezogen. Diese wurde nach dem Beerschen Gesetz mit Reflexion an der Kühlseite und unter Vernachlässigung des Ausbleicheffekts durchgeführt.

Als Parameter wurden angenommen:
Pumplänge 10mm (Fig.13 und Fig.17), 1mm (Fig.9)
Pumpbreite 0.1mm (Fig.13 und Fig.17), 1mm (Fig.9)
Absorptionskoeffizient α =15cm⁻¹
Pumpleistung 200W (absorbiert 120W)
Wärmewirkungsgrad ηₕ = 35%, also Wärmeleistung 42 W
Wärmeleitfähigkeit λ = 5.1 W/(m*K)

Alle Parameter wurden als temperaturunabhängig angenommen.

Die Fig.9-12 stellen die Verhältnisse bei der Simulation eines Festkörpers und Pumplichtstrahls zugehöriger Geometrie des Stands der Technik dar. Die Grössenangaben erfolgen in mm, die Temperaturangaben in Grad Kelvin als Differenz gegenüber der Temperatursenke.

In Fig.9 ist das der Simulation zugrundeliegende Modell nach der Methode der finiten Elemente dargestellt. Betrachtet wird ein Lasermedium eines Thin-Disk-Lasers mit quadratischem Querschnitt auf den ein kreisrunder Pumplichtstrahl eingestrahlt wird. Das Lasermedium ist ein homogener und dotierter Festkörper. Aus Symmetriegründen ist es hinreichend - wie dargestellt - nur eine Hälfte des Festkörpers zu simulieren. Angegeben sind die drei Achsen des Festkörpers.

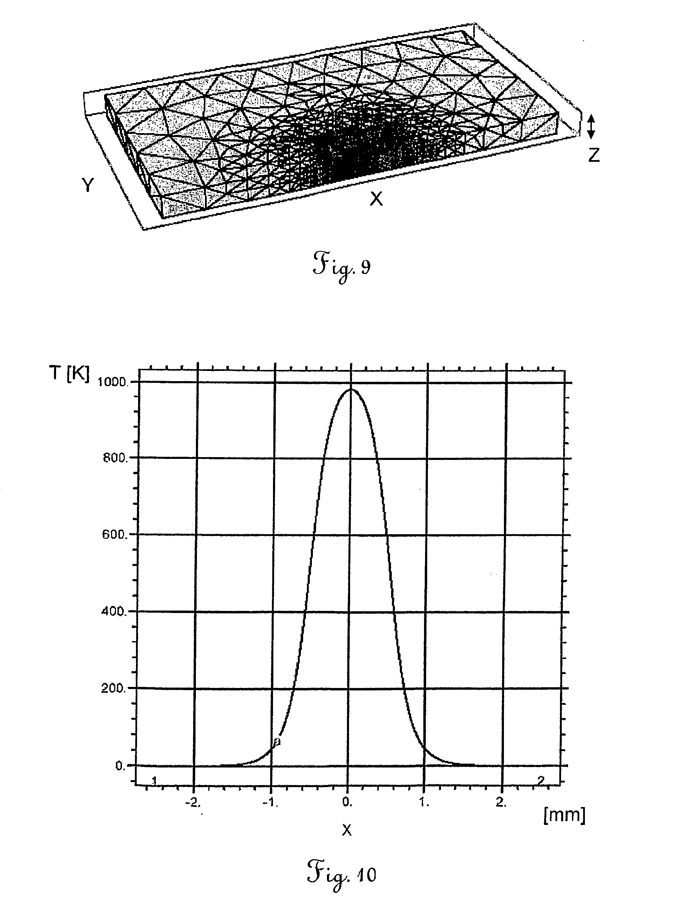

Fig. 10 zeigt den Temperaturverlauf auf der Oberfläche des Festkörpers gem. Fig.9 entlang der X-Achse. Das Zentrum des Pumplichtflecks heizt sich im dargestellten Beispiel bis auf fast 1000° Kelvin als Differenz gegenüber der Temperatursenke auf.

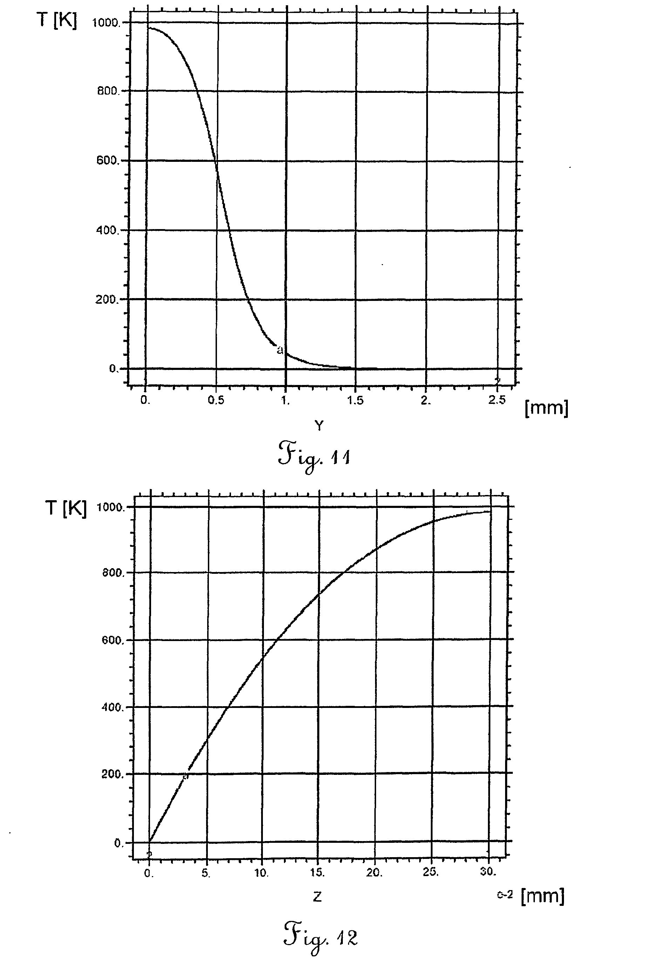

Fig.11 zeigt den Temperaturverlauf auf der Oberfläche des Festkörpers gem. Fig.9 entlang der Y-Achse. Da nur eine Hälfte der symmetrischen Anordnung simuliert wurde, entspricht der Temperaturverlauf im wesentlichen der rechten Hälfte des Temperaturverlaufs gemäss Fig.10.

Fig. 12 zeigt den Temperaturverlauf im Inneren des Festkörpers gem. Fig.9 entlang der Z-Achse.

Die Fig.13-16 stellen die Verhältnisse bei der Simulation einer ersten Ausführungsform eines Festkörpers und zugehörigen Pumplichtstrahls in einer erfindungsgemäßen Laseranordnung dar. Das Lasermedium ist ein homogener und dotierter Festkörper. Die Grössenangaben erfolgen in mm, die Temperaturangaben in Grad Kelvin als Differenz gegenüber der Temperatursenke.

In Fig.13 ist das der Simulation zugrundeliegende Modell nach der Methode der finiten Elemente dargestellt. Betrachtet wird eine erste Ausführungsform eines Lasermediums für einen erfindungsgemässen Thin-Disk-Laser, wobei das Lasermedium länglich ausgebildet ist und einen rechteckigen Querschnitt aufweist. Auf das Lasermedium als Festkörper wird ein länglicher bzw. elliptischer Pumplichtstrahl eingestrahlt. Aus Symmetriegründen ist es hinreichend - wie dargestellt - nur eine Hälfte des Festkörpers zu simulieren. Angegeben sind die drei Achsen des Festkörpers. Sowohl die Dimension in X- als auch in Y-Richtung ist größer als die Dicke des Festkörpers (Z-Richtung). Die eingestrahlte Gesamtleistung entspricht der des Beispiels von Fig.9-12.

Fig. 14 zeigt den Temperaturverlauf auf der Oberfläche des Festkörpers gem. Fig.13 entlang der X-Achse. Das Zentrum des Pumplichtflecks heizt sich im dargestellten Beispiel nur noch bis auf ca. 270° Kelvin als Differenz gegenüber der Temperatursenke auf.

Fig.15 zeigt den Temperaturverlauf auf der Oberfläche des Festkörpers gem. Fig.13 entlang der Y-Achse. Im Gegensatz zum Temperaturverlauf gemäss Fig.11 bildet sich bei der erfindungsgemäßen Ausführungsform in Längsrichtung ein Bereich im wesentlichen konstanter und deutlich geringerer Temperatur aus.

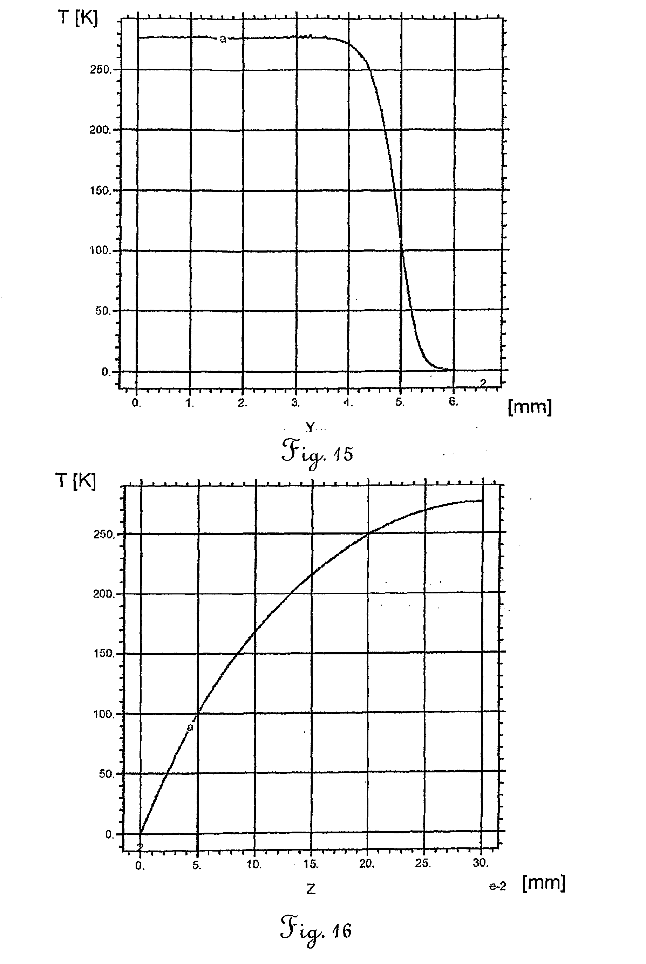

Fig. 16 zeigt den Temperaturverlauf im Inneren des Festkörpers gem. Fig.13 entlang der Z-Achse.

Die Fig.17-20 stellen die Verhältnisse bei der Simulation einer zweiten Ausführungsform eines Festkörpers und zugehörigen Pumplichtstrahls in einer erfindungsgemäßen Laseranordnung dar. Das Lasermedium ist ein heterogener Festkörper mit einem dotierten und einem nicht-dotierten Bereich. Die Grössenangaben erfolgen in mm, die Temperaturangaben in Grad Kelvin als Differenz gegenüber der Temperatursenke.

In Fig.17 ist das der Simulation zugrundeliegende Modell nach der Methode der finiten Elemente dargestellt. Betrachtet wird eine zweite Ausführungsform eines Lasermediums für einen erfindungsgemässen Thin-Disk-Laser, wobei das Lasermedium länglich ausgebildet ist und einen rechteckigen Querschnitt aufweist. Im Gegensatz zur Fig.13 besteht der Festkörper jedoch aus einem ersten Bereich aus dotiertem Material auf den ein zweiter Bereich aus nicht-dotiertem oder einem anderen nicht-aktiven Material aufgebracht wurde. Auf die Oberfläche dieses Gesamtfestkörpers wird ein länglicher bzw. elliptischer Pumplichtstrahl eingestrahlt. Aus Symmetriegründen ist es hinreichend - wie dargestellt - nur eine Hälfte des Festkörpers zu simulieren. Angegeben sind die drei Achsen des Festkörpers. Sowohl die Dimension in X- als auch in Y-Richtung ist größer als die Dicke des Festkörpers (Z-Richtung). Die eingestrahlte Gesamtleistung und Leistungsdichte - und somit der rechnerische Kleinsignal-Verstärkungsfaktor - entsprechen der des Beispiels von Fig.9-12 bzw. von Fig.13-16.

Fig. 18 zeigt den Temperaturverlauf im Maximum im Inneren des Festkörpers gem. Fig.17 entlang der X-Achse. Das Zentrum des Pumplichtflecks heizt sich im dargestellten Beispiel nur noch bis auf ca. 190° Kelvin als Differenz gegenüber der Temperatursenke auf.

Fig.19 zeigt den Temperaturverlauf im Maximum im Inneren des Festkörpers gem. Fig.17 entlang der Y-Achse. Im Gegensatz zum Temperaturverlauf gemäss Fig.11 bildet sich auch hier bei der erfindungsgemäßen Ausführungsform in Längsrichtung ein Bereich im wesentlichen konstanter Temperatur aus.

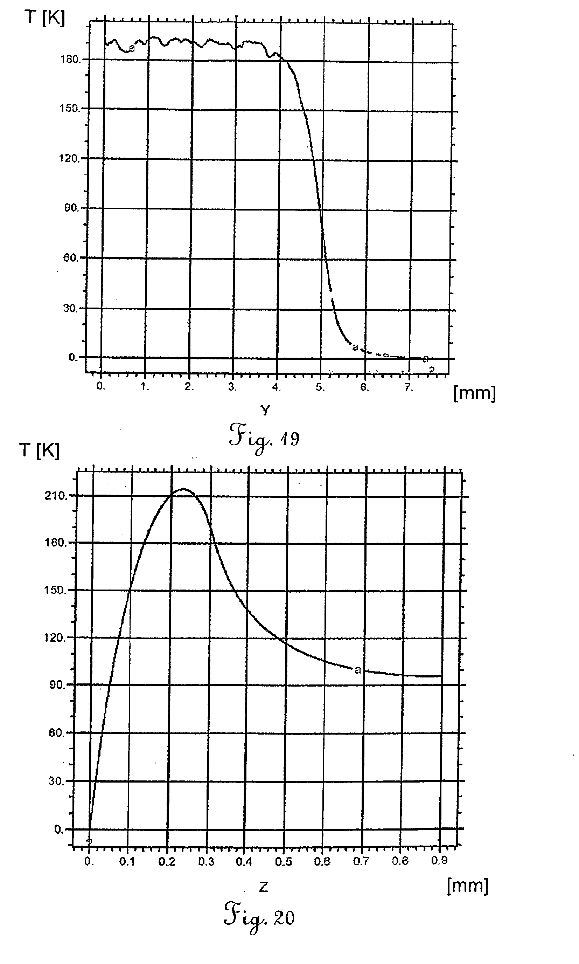

Fig. 20 zeigt den Temperaturverlauf im Inneren des Festkörpers gem. Fig.17 entlang der Z-Achse. Durch den Bereich undotierten Materials wird eine verbesserte Abkühlung bewirkt. Das Temperaturmaximum liegt nun im Inneren des Festkörpers.

In Fig.21 wird ein Beispiel für eine erfindungsgemäße Laseranordnung dargestellt. Als Lichtquelle zum Pumpen des Lasermediums 1 werden Laserdioden 6 als Emitter bzw. Lichtquellen von Teilstrahlen verwendet, die in einem Array linear angeordnet sind. Der jeweilige Teilstrahl S dieser Laserdioden 6 wird über ein erstes optisches Element 7 und ein zweites optisches Element 8 als Pumplichtstrahl auf das auf der Temperatursenke 2 angebrachte Lasermedium 1 abgebildet. Bei diesem Aufbau wird das Licht jeder Laserdiode 6 so in einen gemeinsamen länglichen Pumplichtfleck abgebildet, daß die Lichtflecke weitgehend überlappen und ein Ausfall eines einzelnen Emitters nicht die Struktur des Pumpflecks verändert. Durch die Divergenz des von der Laserdiode 6 ausgehenden Lichts und der Umlenkung durch das zweite optische Element 8 kann ein länglicher Pumplichtfleck auf dem Lasermedium 1 erzeugt werden, welcher der Form des Lasermediums 1 entspricht. Dieser Aufbau stellt nur ein mögliches Beispiel der Strahlerzeugung und -führung dar. Insbesondere kann auch ein Strahlgang unter Verwendung von Mehrfachreflexionen mit diesem Konzept verwirklicht werden. Auch kann die lineare Struktur eines Laserarrays genutzt werden, um direkt einen länglichen Pumplichtfleck zu erzeugen. Als erstes und zweites optisches Element können beispielsweise Zylinderlinsen verwendet werden, wobei aber auch andere Ausführungsformen z.B. Hologrammen oder gradientenoptischen Komponenten realisierbar sind.

Es versteht sich, dass die dargestellten Figuren eine von vielen Ausführungsformen darstellen und der Fachmann alternative Realisierungsformen des Laseraufbaus, z.B. unter Verwendung anderer Laser-Set-ups oder Resonatorkomponenten, ableiten kann. Insbesondere ist es möglich, die Strahlführung oder den Querschnitt des Pumplichtes über die angegebenen Beispiele hinaus anders zu gestalten, beispielsweise durch eine geeignete Ausformung oder Anordnung von reflektierenden Flächen.

## Patentansprüche

1. Thin-Disk-Laser-Pumpverfahren mit
- einem Lasermedium (1),
- einer Temperatursenke (2), auf welcher das Lasermedium (1) angeordnet ist und
- wenigstens einer Lichtquelle zur Erzeugung eines Teilstrahls (S),
mit den Schritten
• Erzeugen des Pumplichts aus dem wenigstens einen Teilstrahl der wenigstens einen Lichtquelle,
• Einstrahlen des Pumplichts auf eine der Temperatursenke (2) gegenüber liegende Eintrittsfläche des Lasermediums (1),
**dadurch gekennzeichnet, dass**
beim Einstrahlen des Pumplichts auf der Eintrittsfläche ein Pumplichtfleck (P) mit einem Verhältnis von Länge zu Breite von wenigstens 2:1 erzeugt und ein zweidimensionaler Wärmefluss bewirkt wird, wobei der Pumplichtfleck (P) durch einen einzigen Teilstrahl (S) oder die Kombination von mehreren Teilstrahlen (S) gebildet wird.

2. Thin-Disk-Laser-Pumpverfahren nach Anspruch 1,
**dadurch gekennzeichnet, daß**
die Breite des Pumplichtflecks kleiner als die Dicke des Lasermediums (1) ist, insbesondere die Breite des Pumplichtflecks 0,1 mm beträgt und die Dicke des Lasermediums (1) grösser als 0,3 mm ist, insbesondere 0,9 mm ist.

3. Thin-Disk-Laser-Pumpverfahren nach Anspruch 1 oder 2,
**dadurch gekennzeichnet, daß**
beim Einstrahlen der Pumplichtfleck (P) durch das Aneinanderreihen der Teilstrahlen (S) mehrerer Lichtquellen gebildet wird.

4. Thin-Disk-Laser-Pumpverfahren nach Anspruch 1 oder 2,
**dadurch gekennzeichnet, daß**
beim Einstrahlen der Pumplichtfleck (P) durch die Teilstrahlen mehrerer Lichtquellen mit einem weitgehenden Überlappen der Teilstrahlen (S) gebildet wird.

5. Thin-Disk-Laser-Pumpverfahren nach Anspruch 1 oder 2,
**dadurch gekennzeichnet, daß**
beim Einstrahlen der Pumplichtfleck (P) durch das Aneinanderreihen von multiplen Projektionen (5") des Teilstrahls (S) der Lichtquelle gebildet wird.

6. Thin-Disk-Laser-Pumpverfahren nach Anspruch 5,
**dadurch gekennzeichnet, daß**
die multiplen Projektionen (5") durch eine mehrfache Reflexion des Teilstrahls (S) der Lichtquelle an einer reflektierenden Fläche (4') bewirkt werden.

7. Thin-Disk-Laser-Pumpverfahren nach einem der vorangehenden Ansprüche,
**dadurch gekennzeichnet, daß**
beim Einstrahlen der Pumplichtfleck (P) mit einem Verhältnis von Länge zu Breite von wenigstens 3:1, 5:1 oder 10:1 erzeugt wird.

8. Thin-Disk-Laser-Pumpverfahren nach einem der vorangehenden Ansprüche,
**dadurch gekennzeichnet, daß**
nach einem Reflektieren des Pumplichts an einer Grenzfläche zur Temperatursenke das Pumplicht eine Rückreflexion erfährt.

9. Thin-Disk-Laser-Pumpverfahren nach einem der vorangehenden Ansprüche,
**dadurch gekennzeichnet, daß**
innerhalb des Lasermediums (1) eine mehrfache Reflexion des Pumplichts erfolgt.

10. Thin-Disk-Laseranordnung mit
• wenigstens einer Lichtquelle zum Erzeugen eines Teilstrahls (S),
• einem Laserelement mit einer Temperatursenke (2) und einer ersten Komponente (1a) mit einem laseraktivem Material, wobei die erste Komponente (1a) und die Temperatursenke (2) miteinander durch eine wärmeleitende Verbindung verbunden sind,
• Mittel zum Einstrahlen von Pumplicht auf eine Eintrittsfläche des Laserelements, wobei die Mittel zum Einstrahlen so angeordnet und ausgebildet sind, dass das Einstrahlen auf eine der Temperatursenke (2) gegenüber liegende Eintrittsfläche des Lasermediums (1) erfolgt,
**dadurch gekennzeichnet**, das
die Mittel zum Einstrahlen von Pumplicht so ausgebildet und angeordnet sind, dass ein Pumplichtfleck (P) mit einem Verhältnis von Länge zu Breite von wenigstens 2:1 ausgebildet und ein zweidimensionaler Wärmefluss bewirkt wird, wobei der Pumplichtfleck (P) aus einem einzigen Teilstrahl (S) oder der Kombination von mehreren Teilstrahlen (S) besteht.

11. Thin-Disk-Laseranordnung nach Anspruch 10,
**dadurch gekennzeichnet, dass**
die Breite des Pumplichtflecks kleiner als die Dicke des Lasermediums (1) ist, insbesondere die Breite des Pumplichtflecks 0,1 mm beträgt und die Dicke des Lasermediums (1) grösser als 0,3 mm ist, insbesondere 0,9 mm ist.

12. Thin-Disk-Laseranordnung nach Anspruch 10 oder 11,
**dadurch gekennzeichnet, dass**
• zwischen erster Komponente (1a) und Temperatursenke (2) eine reflektierende erste Fläche, insbesondere als reflektierende Schicht (3), ausgebildet ist und
• die Mittel zum Einstrahlen des Pumplichts eine planare reflektierende zweite Fläche (4') zur Faltung des Strahlgangs des Teilstrahls (S) aufweisen, wobei die reflektierenden Flächen (3,4') so angeordnet sind, dass
a. die reflektierenden Flächen (3,4')
i. gegeneinander und
ii. mit, insbesondere einstellbarem, divergentem Verlauf der Flächen (3,4')
orientiert sind, und
b. der Teilstrahl (S) an wenigstens einer der reflektierenden Flächen (3,4') wenigstens zweimal reflektiert wird.

13. Thin-Disk-Laseranordnung nach Anspruch 10 oder 11,
**gekennzeichnet durch**
mehrere linear angeordnete Halbleiterlaserdioden (6) als Lichtquellen,
wobei
• die Mittel zum Einstrahlen des Pumplichts ein erstes optisches Element (7) und eine zweites optisches Element (8) aufweisen,
• das erste optische Element (7) jeden Teilstrahl in einer ersten Ebene kollimiert,
• das zweite optische Element (8) jeden Teilstrahl in einer zweiten, zur ersten Ebene im wesentlichen senkrechten Ebene kollimiert und die Teilstrahlen (S) so lenkt, dass der Pumplichtfleck (P) **durch**
o ein Aneinanderreihen der Teilstrahlen (S) oder
o einen weitgehenden Überlapp der Teilstrahlen (S) definiert ist.

14. Thin-Disk-Laseranordnung nach Anspruch 13,
**dadurch gekennzeichnet, dass**
das erste optische Element (7) eine Zylinderlinse ist und/oder das zweite optische Element (8) eine Zylinderlinse ist.

15. Thin-Disk-Laseranordnung nach einem der Ansprüche 10 bis 14,
**gekennzeichnet durch**
einen Strahlgang, der so ausgebildet ist, insbesondere durch eine Anordnung von Faltspiegeln, dass der Lasermode mehrfach **durch** das Laserelement propagiert.

16. Thin-Disk-Laseranordnung nach Anspruch 15,
**dadurch gekennzeichnet, dass**
der Strahlgang in einem Resonator oder in einen unidirektionalen Verstärker ausgebildet ist.

17. Thin-Disk-Laseranordnung nach einem der Ansprüche 10 bis 16,
**gekennzeichnet durch**
einen rechteckigen Querschnitt der wärmeleitenden Verbindung, insbesondere mit einem Verhältnis von Länge zu Breite von wenigstens 2:1.

18. Thin-Disk-Laseranordnung nach einem der Ansprüche 10 bis 17,
**dadurch gekenzzeichnet, dass**
das Lasermedium eine zweite Komponente (1b) aus einem Material aufweist, das einen zum laseraktiven Material identischen Brechungsindex besitzt, wobei die zweite Komponente (1b) mit der ersten Komponente auf einer der Temperatursenke (2) abgewandten Seite wärmeleitend verbunden ist.

19. Thin-Disk-Laseranordnung nach Anspruch 18,
**dadurch gekennzeichnet, daß**
erste Komponente (1a) und zweite Komponente (1b) aus einem identischen Basismaterial bestehen und sich nur durch eine Dotierung unterscheiden.

20. Thin-Disk-Laseranordnung nach Anspruch 18 oder 19,
**dadurch gekennzeichnet, daß**
erste Komponente (1a) und zweite Komponente (1b) als ein monolithischer Festkörper ausgebildet sind, wobei wenigstens eine parallel zur Temperatursenke (2) verlaufende Dimension des Festkörpers größer ist als dessen senkrecht zur Temperatursenke gemessene Dicke.

21. Thin-Disk-Laseranordnung nach Anspruch 20,
**dadurch gekennzeichnet, daß**
der Festkörper eine streifenförmige oder barrenförmige Geometrie aufweist.

22. Thin-Disk-Laseranordnung nach einem der Ansprüche 20 oder 21,
**gekennzeichnet durch**
eine reflektierende Schicht (3) zwischen Festkörper und Temperatursenke (2).

23. Thin-Disk-Laseranordnung nach einem der Ansprüche 20 bis 22,
**gekennzeichnet durch**
eine reflexmindernde und/oder abriebfeste Schicht (1c) auf einer der Temperatursenke (2) abgewandten Seite des Festkörpers.

## Claims

1. Thin-disc laser pumping method comprising
- a laser medium (1),
- a temperature sink (2) on which the laser medium (1) is arranged and
- at least one light source for producing a partial beam (S),
comprising the steps
• producing pump light from the at least one partial beam of the at least one light source,
• projecting the pump light onto an entrance area of the laser medium (1) which is located opposite the temperature sink (2),
**characterized in that**, when the pump light is incident on the entrance area, a pump light spot (P) having a ratio of length to width of at least 2:1 is produced and a two-dimensional heat flow is realised, the pump light spot (P) being formed by a single partial beam (S) or the combination of a plurality of partial beams (S).

2. Thin-disc laser pumping method according to Claim 1, **characterized in that** the width of the pump light spot is less than the thickness of the laser medium (1), in particular the width of the pump light spot is 0.1 mm and the thickness of the laser medium (1) is greater than 0.3 mm, in particular 0.9 mm.

3. Thin-disc laser pumping method according to Claim 1 or 2, **characterized in that**, on projection, the pump light spot (P) is formed by the arrangement of the partial beams (S) of a plurality of light sources in a row.

4. Thin-disc laser pumping method according to Claim 1 or 2, **characterized in that**, on projection, the pump light spot (P) is formed by the partial beams of a plurality of light sources with substantial overlap of the partial beams (S).

5. Thin-disc laser pumping method according to Claim 1 or 2, **characterized in that**, on projection, the pump light spot (P) is formed by the arrangement of multiple projections (5'') of the partial beam (S) of the light source in a row.

6. Thin-disc laser pumping method according to Claim 5, **characterized in that** the multiple projections (5'') are realized by multiple reflection of the partial beam (S) of the light source by a reflecting surface (4').

7. Thin-disc laser pumping method according to any of the preceding Claims, **characterized in that**, on projection, the pump light spot (P) is produced with a ratio of length to width of at least 3:1, 5:1 or 10:1.

8. Thin-disc laser pumping method according to any of the preceding Claims, **characterized in that**, after reflection of the pump light at an interface with the temperature sink, the pump light experiences back-reflection.

9. Thin-disc laser pumping method according to any of the preceding Claims, **characterized in that** multiple reflection of the pump light takes place within the laser medium (1).

10. Thin-disc laser arrangement comprising
• at least one light source for producing a partial beam (S),
• a laser element having a temperature sink (2) and a first component (1a) comprising a laser-active material, the first component (1a) and the temperature sink (2) being connected to one another by a heat-conducting connection,
• means for projecting the pump light onto an entrance area of the laser element, the means for projecting being arranged and formed so that projecting takes place onto an entrance area of the laser medium (1) which is opposite the temperature sink (2),
**characterized in that** the means for projecting pump light is formed and arranged so that a pump light spot (P) having a ratio of length to width of at least 2:1 is formed and a two-dimensional heat flow is realised, the pump light spot (P) consisting of a single partial beam (S) or the combination of a plurality of partial beams (S).

11. Thin-disc laser arrangement according to Claim 10, **characterized in that** the width of the pump light spot is less than the thickness of the laser medium (1), in particular the width of the pump light spot is 0.1 mm and the thickness of the laser medium (1) is greater than 0.3 mm, in particular 0.9 mm.

12. Thin-disc laser arrangement according to Claim 10 or 11, **characterized in that**
• a reflecting first surface, in particular a reflecting layer (3) is formed between first component (1a) and temperature sink (2) and
• the means for projecting the pump light have a planar reflecting second surface (4') for folding the beam path of the partial beam (S), the reflecting surfaces (3, 4') being arranged so that
a. the reflecting surfaces (3, 4') are oriented
i. opposite one another and
ii. with, in particular adjustable, divergence of the surfaces (3, 4'),
and
b. the partial beam (S) is reflected at least twice by at least one of the reflecting surfaces (3, 4').

13. Thin-disc laser arrangement according to Claim 10 or 11, **characterized by** a plurality of linearly arranged semiconductor laser diodes (6) as light sources,
• the means for projecting the pump light having a first optical element (7) and a second optical element (8),
• the first optical element (7) collimating each partial beam in a first plane,
• the second optical element (8) collimating each partial beam in a second plane substantially perpendicular to the first plane and guiding the partial beams (S) so that the pump light spot (P) is defined by
o arrangement of the partial beams (S) in a row or
o substantial overlap of the partial beams (S).

14. Thin-disc laser arrangement according to Claim 13, **characterized in that** the first optical element (7) is a cylindrical lens and/or the second optical element (8) is a cylindrical lens.

15. Thin-disc laser arrangement according to any of Claims 10 to 14, **characterized by** a beam path which is formed, in particular by an arrangement of folding mirrors, so that the laser mode propagates several times through the laser element.

16. Thin-disc laser arrangement according to Claim 15, **characterized in that** the beam path is formed in a resonator or in a unidirectional amplifier.

17. Thin-disc laser arrangement according to any of Claims 10 to 16, **characterized by** a rectangular cross-section of the heat-conducting connection, in particular having a ratio of length to width of at least 2:1.

18. Thin-disc laser arrangement according to any of Claims 10 to 17, **characterized in that** the laser medium has a second component (1b), comprising a material which has a refractive index identical to that of the laser-active material, the second component (1b) having a heat-conducting connection to the first component on the side facing away from the temperature sink (2).

19. Thin-disc laser arrangement according to Claim 18, **characterized in that** first component (1a) and second component (1b) consist of an identical base material and differ only through doping.

20. Thin-disc laser arrangement according to Claim 18 or 19, **characterized in that** first component (1a) and second component (1b) are in the form of a monolithic solid, at least one dimension of the solid which is parallel to the temperature sink (2) being greater than the thickness thereof measured perpendicular to the temperature sink.

21. Thin-disk laser arrangement according to Claim 20, **characterized in that** the solid has a strip-shaped or ingot-shaped geometry.

22. Thin-disc laser arrangement according to either of Claims 20 and 21, **characterized by** a reflecting layer (3) between solid and temperature sink (2).

23. Thin-disc laser arrangement according to any of Claims 20 to 22, **characterized by** a reflection-reducing and/or abrasion-resistant layer (1c) on a side of the solid which faces away from the temperature sink (2).

## Revendications

1. Procédé pour pomper un laser thin-disk, comprenant :
- un milieu laser (1),
- un puits à température (2), sur lequel est disposé le milieu laser (1), et
- au moins une source de lumière, pour produire un rayon partiel (S),
comprenant les étapes suivantes :
• production de la lumière de pompage, à partir d'au moins un rayon partiel de la au moins une source de lumière,
• émission de la lumière de pompage rayonnée sur une face d'entrée, située à l'opposé du puits de température (2), du milieu laser (1),
**caractérisé en ce que**,
lors de l'entrée du rayon de lumière de pompage sur la face d'entrée, une tache de lumière de pompage (P), d'un rapport entre la longueur et la largeur d'au moins 2:1, est produite et un flux thermique bidimensionnel est provoqué, sachant que la tache de lumière de pompage (P) est formée par un rayon partiel (S) unique, ou par la combinaison de plusieurs rayons partiels (S).

2. Procédé pour pomper un laser thin-disk selon la revendication 1, **caractérisé en ce que**
la largeur de la tache de lumière de pompage est inférieure à l'épaisseur du milieu laser (1), en particulier la largeur de la tache de lumière de pompage est de 0,1 mm et l'épaisseur du milieu laser (1) est supérieur à 0,3 mm, en particulier 0,9 mm.

3. Procédé pour pomper un laser thin-disk selon la revendication 1 ou 2, **caractérisé en ce que**,
lors de l'entrée du rayonnement, la tache de lumière de pompage (P) est formée par l'alignement en rangée des rayons laser (S) de plusieurs sources de lumière.

4. Procédé pour pomper un laser thin-disk selon la revendication 1 ou 2, **caractérisé en ce que**,
lors de l'entrée du rayonnement, la tache de lumière de pompage (P) est formée par les rayons partiels de plusieurs sources de lumière, avec un chevauchement important des rayons partiels (S).

5. Procédé pour pomper un laser thin-disk selon la revendication 1 ou 2, **caractérisé en ce que**,
lors de l'entrée du rayonnement, la tache de lumière de pompage (P) est formée par l'alignement en rangée d'une pluralité de projections (5") du rayon partiel (S) de la source de lumière.

6. Procédé pour pomper un laser thin-disk selon la revendication 5, **caractérisé en ce que**
la pluralité de projections (5") est provoquée par une réflexion multiple du rayon partiel (S) de la source de lumière, sur une surface (4') réfléchissante.

7. Procédé pour pomper un laser thin-disk selon l'une des revendications précédentes, **caractérisé en ce que**,
lors de l'entrée du rayonnement, la tache de lumière de pompage (P) est produite avec un rapport entre longueur et largeur d'au moins 3:1, 5:1 ou 10:1.

8. Procédé pour pomper un laser thin-disk selon l'une des revendications précédentes, **caractérisé en ce que**,
après une réflexion de la lumière de pompage sur une surface limite, au puits de température, la lumière de pompage subit une rétroréflexion.

9. Procédé pour pomper un laser thin-disk selon l'une des revendications précédentes, **caractérisé en ce qu'**
une réflexion multiple de la lumière de pompage est effectuée à l'intérieur du milieu laser (1).

10. Dispositif laser thin-disk comprenant :
• au moins une source de lumière, pour produire un rayon partiel (S),
• un élément laser, ayant un puits de température (2) et un premier composant (la), avec un matériau actif pour un laser, le premier composant (1a) et le puits de température (2) étant reliés ensemble par une liaison conductrice de la chaleur,
• des moyens, pour introduire un rayon de lumière de pompage sur une surface d'entrée de l'élément laser, les moyens pour introduire un rayon étant disposés et configurés de manière que l'entrée du rayon se fasse sur une surface d'entrée, opposée au puits de température (2), du milieu laser (1),
**caractérisé en ce que**
les moyens pour faire entrer un rayon de lumière de pompage sont réalisés et agencés de manière qu'une tache de lumière de pompage (P), ayant un rapport entre longueur et largeur d'au moins 2:1, soit réalisée et qu'un flux de chaleur bidimensionnel soit provoqué, la tache de lumière de pompage (P) étant formée d'un rayon partiel (S) unique, ou d'une combinaison de plusieurs rayons partiels (S).

11. Dispositif laser thin-disk selon la revendication 10, **caractérisé en ce que**
la largeur de la tache de lumière de pompage est inférieure à l'épaisseur du milieu laser (1), en particulier la largeur de la tache de lumière de pompage est de 0,1 mm, et l'épaisseur du milieu laser (1) est supérieure à 0,3 mm, en particulier est de 0,9 mm.

12. Dispositif laser thin-disk selon la revendication 11, **caractérisé en ce qu'**
• entre le premier composant (1a) et le puits de température (2) est réalisée une première surface réfléchissante, en particulier sous forme de couche (3) réfléchissante, et
• les moyens pour faire entrer la lumière de pompage présentent une deuxième surface (4') réfléchissante plane, pour pliage du trajet de rayonnement du rayon partiel (S), les surfaces réfléchissantes (3,4') étant disposées de manière que
a. les surfaces réfléchissantes (3,4')
i. soient opposées et
ii. soient orientées avec une allure divergente, en particulier réglable, des surfaces (3,4'), et
b. le rayon partiel (S) est réfléchi au moins deux fois en au moins l'une des surfaces réfléchissantes (3,4').

13. Dispositif laser thin-disk selon la revendication 10 ou 11, **caractérisé par**
une pluralité de diodes laser à semi-conducteurs (6), disposées de façon linéaire, en tant que sources de lumière,
où
• les moyens pour faire entrer la lumière de pompage présentent un premier élément optique (7) et un deuxième élément optique (8)
• le premier élément optique (7) collimate chaque rayon partiel dans un premier plan
• le deuxième élément optique (8) collimate chaque rayon partiel en un deuxième plan, sensiblement perpendiculaire au premier plan, et dévie les rayons partiels (S) de manière que la tache de lumière de pompage (P) soit définie par
o un alignement en rangée des rayons partiels (S), ou
o un chevauchement important des rayons partiels (S).

14. Dispositif laser thin-disk selon la revendication 13, **caractérisé en ce que**
le premier élément optique (7) est une lentille cylindrique et/ou le deuxième élément optique (8) est une lentille cylindrique.

15. Dispositif laser thin-disk selon l'une des revendications 10 ou 14, **caractérisé par**
un trajet des rayons, réalisé de manière que, en particulier grâce à un agencement de miroirs de repli, le mode laser se propage plusieurs fois à travers l'élément laser.

16. Dispositif laser thin-disk selon la revendication 15, **caractérisé en ce que**
le trajet de rayons est réalisé dans un résonateur ou dans un amplificateur unidirectionnel.

17. Dispositif laser thin-disk selon l'une des revendications 10 à 16, **caractérisé par** une section transversale rectangulaire de la liaison conductrice de la chaleur, en particulier avec un rapport entre la longueur et la largeur d'au moins 2:1.

18. Dispositif laser thin-disk selon l'une des revendications 10 à 17, **caractérisé en ce que**
le milieu laser présente un deuxième composant (1b), formé d'un matériau ayant un indice de réfraction identique au matériau actif en laser, le deuxième composant (1b) étant relié au premier composant de façon conductrice de la chaleur, sur une face opposée au puits de température (2).

19. Dispositif laser thin-disk selon la revendication 18, **caractérisé en ce que**
le premier composant (1a) et le deuxième composant (1b) sont formés d'un matériau de base identique et ne se distinguent que par un dopage.

20. Dispositif laser thin-disk selon la revendication 18 ou 18, **caractérisé en ce que**
le premier composant (1a) et le deuxième composant (1b) sont réalisés sous la forme de corps solide monolithique, au moins une dimension, s'étendant parallèlement au puits de température (2) du corps solide, étant supérieure à son épaisseur, mesurée perpendiculairement au puits de température.

21. Dispositif laser thin-disk selon la revendication 20, **caractérisé en ce que**
le corps solide présente une géométrie en forme de bande ou en forme de barre.

22. Dispositif laser thin-disk selon l'une des revendications 20 ou 21, **caractérisé par**
une couche (3) réfléchissante, entre le corps solide et le puits de température (2).

23. Dispositif laser thin-disk selon l'une des revendications 20 à 22, **caractérisé par**
une couche (1c) diminuant la réflexion et/ou résistante à l'abrasion, sur une face du corps solide opposée au puits de température (2).
